# EUROPEAN PATENT APPLICATION

(11) **EP 2 769 957 A2**
(43) Date of publication of application: **27.08.2014**
(21) Application number: 14153797.7
(22) Date of filing: 04.02.2014
(51) Int. Cl.: B81B 7/00

(54) **Vacuum sealed semiconductor device and method of manufacturing the same**

(30) Priority: 21.02.2013 JP 2013032383; 14.01.2014 JP 2014004274
(71) Applicant: Ricoh Company, Ltd., Tokyo 143-8555 (JP)
(72) Inventor: Ando, Yuichi, Tokyo 143-8555 (JP); Sato, Yukito, Tokyo 143-8555 (JP); Mae, Katsunori, Tokyo 143-8555 (JP)
(74) Representative: Schwabe - Sandmair - Marx

(57) **Abstract**

A device including a first substrate in which a functional element and an electrode are formed; a second substrate in which a through electrode is formed; a joining material that joins the first substrate and the second substrate while reserving a predetermined space between the functional element and the second substrate; and a conductive material that electrically connects the electrode to the through electrode. Here, the joining material is harder than the conductive material, and the joining material is electrically less conductive than the conductive material.

## Description

### BACKGROUND OF THE INVENTION

### 1. Field of the Invention

The present invention relates to a device, a semiconductor device, and a method of manufacturing the device.

### 2. Description of the Related Art

A Micro-Electro Mechanical Systems (MEMS) device is manufactured by using semiconductor technology. An MEMS device includes both an electric circuit element and a fine mechanical element. Such an MEMS device is currently used for an acceleration sensor, a printer head, a pressure sensor, an FIR sensor, or a digital micromirror device (DMD), for example. Its market size is expanding.

In general, an MEMS device includes a movable part (a functional element), which is formed in a hollow shape. Since the movable part is to be protected from external air or the like, the movable part is sealed in vacuum (or under constant pressure). If the vacuum sealing is insufficient, reliability may be degraded, and a malfunction of the MEMS device may be caused.

As a sealing method which is used for an MEMS device, anodic bonding can be considered. In anodic bonding, a silicon substrate, to which a high voltage is applied, is joined with a glass substrate under temperature of from 300 °C to 500 °C. In anodic bonding, since a device substrate is directly joined with a package substrate, a separate cavity may be required for sealing the movable part.

As another sealing method, a method can be considered such that, in a mounting process, a hermetically sealed package substrate is used. Here, the hermetically sealed package substrate is sealed in high vacuum.

Further, it is proposed to join a device substrate with a package substrate, and to integrally seal them, in a wafer manufacturing process (a wafer level) of manufacturing an MEMS device. For example, Patent Document 1 (Japanese Unexamined Patent Publication No. 2010-17805) discloses that a metal layer is disposed in a sealing portion for vacuum sealing, and another metal layer is disposed in an electrical connection portion for electrical connection. These metal layers are formed of the same material. At the wafer level, a cover substrate is joined with an integrated circuit substrate.

Patent Document 2 (Japanese Unexamined Patent Publication No. 2012-49298) discloses that an LTCC substrate and an MEMS substrate are joined by anodic bonding. The LTCC substrate and the MEMS substrate are electrically connected through a porous metal.

Patent Document 3 (Japanese Unexamined Patent Publication No. H05-291388) discloses a technique such that, prior to dicing a wafer into chips, a semiconductor substrate wafer on which an accelerometer is to be formed and a cap wafer are joined by frit glass.

Recently, a technique has been developed to produce a compact device having an advanced feature. In such a technique, a substrate in which various types of elements are formed is laminated on a device formed by joining a device substrate and a package substrate. In the device substrate, a semiconductor functional element (e.g., a sensor, or an optical scanner) is formed.

### SUMMARY OF THE INVENTION

When a substrate (a device substrate) in which a functional element is formed is to be joined with a package substrate, it is desirable that the functional element can be precisely vacuum sealed, and that electrical connection among electrodes which are formed in the corresponding substrates can be ensured. Additionally, it is desirable that joining may be made at low cost. However, a hermetically sealed package substrate, which has been used, may require certain cost for packaging.

It is desirable to make reliable and less expensive bonding.

In Patent Document 1, the metal layers, which are formed of the same material, are used for the sealing portion and the electrical connection portion. In other words, a material which is optimized for vacuum sealing and a material which is optimized for electrical connection are not selected. Thus, reliability of the bonding may be low. Moreover, a metal layer formed of a metal, such as Au or Ag, is expensive.

In Patent Document 2, an anodic bonding process is applied. During the anodic bonding process, an applied voltage and processing temperature can be high, and consequently the MEMS device may be adversely affected. In the anodic bonding, a separate cavity may be required for accommodating a functional element. It may be difficult to join the substrate including the cavity with a flat substrate. Additionally, reliability of bonding may be low, due to precision of alignment of the cavity.

An embodiment of the present invention has been developed in view of the above-described problems. It is desirable to make reliable and less expensive bonding.

According to an aspect of the present invention, there is provided a semiconductor device including a first substrate in which a functional element and an electrode are formed; a second substrate in which a through electrode is formed; a joining material that joins the first substrate and the second substrate, while reserving a predetermined space between the functional element and the second substrate; and a conductive material that electrically connects the electrode to the through electrode, wherein the joining material is harder than the conductive material, and the joining material is electrically less conductive than the conductive material.

According to another aspect of the present invention, there is provided a method of manufacturing a device, the method including a step of forming a functional element and an electrode on a first substrate; a step of forming a conductive material on the electrode; a step of forming a through electrode in a second substrate; a step of forming a joining material on the second substrate, wherein the joining material is harder than the conductive material, and the joining material is electrically less conductive than the conductive material; a step of joining the first substrate and the second substrate through the joining material, while reserving a predetermined space between the functional element and the second substrate; and a step of electrically connecting the electrode to the through electrode through the conductive material.

According to another aspect of the present invention, there is provided a method of manufacturing a device, the method includes a step of forming a functional element and an electrode on a first substrate; a step of forming a conductive material on the electrode; a step of forming a through electrode in a second substrate; a step of forming a joining material on the second substrate, wherein the joining material is harder than the conductive material, and the joining material is electrically less conductive than the conductive material, a step of baking the conductive material and the joining material, while reserving a predetermined space between the functional element and the second substrate; a step of joining the first substrate and the second substrate through the joining material; and a step of electrically connecting the electrode and the through electrode through the conductive material.

According to the embodiment of the present invention, reliable and less expensive joining can be made.

Other objects, features and advantages of the present invention will become more apparent from the following detailed description when read in conjunction with the accompanying drawings.

### BRIEF DESCRIPTION OF THE DRAWINGS

FIG. 1 is a cross-sectional view showing an example of a structure of a device according to an embodiment;
FIG. 2 is a cross-sectional view showing an example of the structure of the device according to the embodiment;
FIG. 3A is a cross-sectional view showing an example of the structure of the device according to the embodiment;
FIG. 3B is a planar transparent view showing the example of the structure of the device according to the embodiment;
FIG. 4 is a cross-sectional view showing an example of the structure of the device according to the embodiment;
FIGS. 5A - 5F are diagrams showing an example of a method of manufacturing the device according to the embodiment;
FIG. 6 is a cross-sectional view showing an example of the structure of the device according to the embodiment;
FIG. 7 is a cross-sectional view showing an example of the structure of the device according to the embodiment;
FIG. 8 is a cross-sectional view showing an example of the structure of the device according to the embodiment;
FIG. 9 is a cross-sectional view showing an example of the structure of the device according to the embodiment;
FIGS. 10A - 10D are diagrams showing an example of the method of manufacturing the device according to the embodiment;
FIGS. 11A - 11D are diagrams showing a continuation of the example of the method of manufacturing the device according to the embodiment;
FIGS. 12A and 12B are diagrams showing an example of the method of manufacturing the device according to the embodiment;
FIGS. 13A and 13B are diagrams showing a continuation of the example of the method of manufacturing the device according to the embodiment;
FIGS. 14A and 14B are diagrams showing a continuation of the example of the method of manufacturing the device according to the embodiment;
FIGS. 15A and 15B are diagrams showing a continuation of the example of the method of manufacturing the device according to the embodiment;
FIG. 16A is a planar transparent view showing an example of the structure of the device according to the embodiment; and
FIG. 16B is a cross-sectional view showing the example of the structure of the device according to the embodiment.

### DETAILED DESCRIPTION OF THE PREFERRED EMBODIMENTS

Hereinafter, an example of a device according to an embodiment of the present invention is explained.

### (Structure of device)

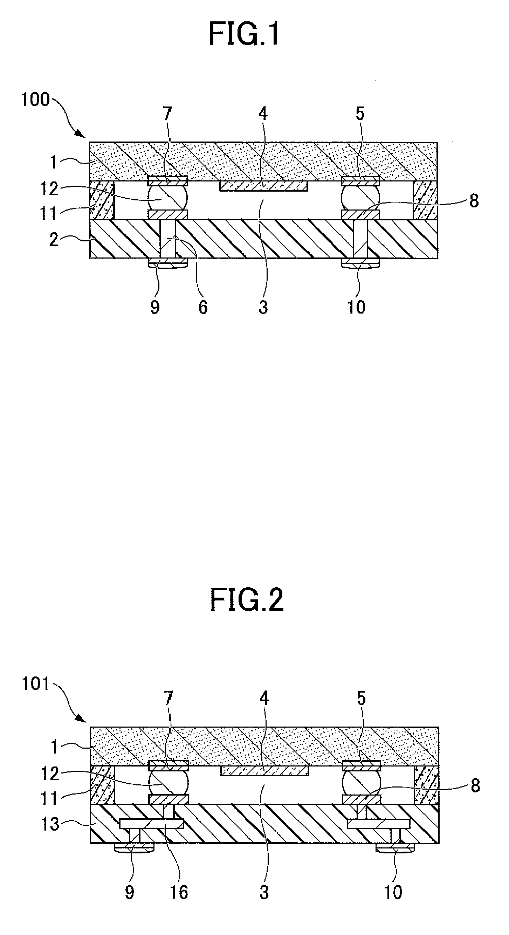

FIG. 1 is a cross-sectional view showing an example of a structure of a device 100 according to an embodiment.

As depicted in FIG. 1, a functional element (e.g., a sensor, or an IC) 4; electrodes 5; and metal thin film pads 7 are formed on a first substrate 1. The electrode 5 and the corresponding metal thin film pad 7 are formed, while the electrode 5 and the corresponding metal thin film pad 7 are laminated.

Through electrodes 6 are formed in a second substrate 2. A metal thin film pad 8 is formed at an end of each of the through electrodes 6, and a metal thin film pad 9 is formed at the other end of the corresponding through electrode 6. Further, a plating layer 10 is laminated on each of the metal thin film pads 9.

A joining material 11 is disposed between the first substrate 1 and the second substrate 2.

A conductive material 12 is disposed between each of the metal thin film pads 7 and the corresponding metal thin film pad 8.

The joining material 11 joins the first substrate 1 with the second substrate 2. The joining material 11 forms a cavity 3 between the functional element 4 and the second substrate 2. The joining material 11 has a function to vacuum seal the functional element 4 in the cavity 3.

The conductive material 12 has a function of electrically connecting the first substrate 1 (which is a device substrate) to the second substrate 2 (which is a package substrate). Specifically, the conductive material 12 is disposed between the metal thin film pad 7 and the corresponding metal thin film pad 8. Here, the metal thin film pad 7 is electrically connected to the functional element 4, and the metal thin film pad 8 is electrically connected to the through electrode 6. In this manner, the functional element 4 and each of the through electrodes 6 formed in the package substrate are electrically connected.

The conductive material 12 and the joining material 11 are formed of corresponding materials, which are different from each other. For a portion for which high stiffness and high degree of vacuum are required, bonding may preferably be made by using the joining material 11, which has high stiffness and low electric conductivity. For a portion for which electric conductivity is required, electrical connection may preferably be made by using the conductive material 12, which is soft and electrically conductive, and which can be easily processed.

As the joining material 11, a material having high bonding strength can preferably be used. By using a material having high bonding strength, vacuum sealing between the first substrate 1 and the second substrate 2 can be ensured.

As the joining material 11, a material may preferably be used that has sufficient stiffness for maintaining a predetermined distance between the first substrate 1 and the second substrate 2. By maintaining the predetermined distance between the first substrate 1 and the second substrate 2, a cavity 3 can be formed, which is for hermetically sealing the functional element 4. By such a configuration, a space for accommodating the functional element 4 may not be separately formed in the package substrate. Additionally, even if flat substrates are used as the first substrate 1 and the second substrate 2, the first substrate 1 and the second substrate 2 can successfully be joined.

As the joining material 11, a material that has sufficient endurance against mechanical stress may preferably be used. By using such a material having endurance against mechanical stress, the joining material 11 may be prevented from receiving mechanical damage during dicing for forming chips (chip segmentation), subsequent to joining a silicon wafer having a large diameter with the joining material 11.

Additionally, as the joining material 11, a less expensive material may preferably be used. By using such a less expensive material, overall cost for bonding can be reduced, even if an area for bonding is enlarged.

Specifically, as the joining material 11, a glass frit material or a polymer resin may preferably be used. As a polymer resin, an epoxy resin, a dry film, a benzocyclobutene (BCB) resin, a polyimide resin, or an ultraviolet-curing resin may be considered. However, heat resistance temperature of a polymer resin may not be high, and hermeticity of a polymer resin may be insufficient.

As the joining material 11, a noble metal may be used, such as Au. However, it may not be preferable to use such a noble metal as the joining material 11, as it may be difficult to reduce cost when a large amount of the noble metal is used as the joining material 11.

As the conductive material 12, a soft material having high electric conductivity may preferably be used that can easily be squashed by pressure and heat during bonding. Further, the conductive material 12 may preferably have endurance against temperature during solder reflow, such as solder joining.

Specifically, a metal, such as Au or Ag; a paste material of an alloy thereof; or a solder material, may preferably be used as the conductive material 12. By using such a material, and by heating and pressing the conductive material 12, interdiffusion of metallic materials occurs between the conductive material 12 and the metal thin film pad 7, and between the conductive material 12 and the metal thin film pad 8, thereby making diffusion joining. Consequently, the functional element 4 and the through electrode 6 in the package substrate can be electrically connected.

In the present specification, the term "diffusion joining" may mean to make electrical connection between the through electrode 6 and the conductive material 12 by heating and pressing the conductive material 12, and by using diffusion of the metallic materials.

The first substrate 1 is a substrate in which the functional element 4 having a moving element, a detecting element, and the like; and an electric circuit are formed. Various films and patterns for forming the functional element 4 and the electric circuit are disposed on the first substrate 1. Silicon can preferably be utilized as a material of the first substrate 1. When silicon is utilized, the silicon substrate may be a bulk substrate, or a silicon-on-insulator (SOI) substrate.

The second substrate 2 is the package substrate for vacuum sealing the functional element 4 (or sealing it in a space in which pressure is adjusted to be less than the atmospheric pressure), which is accommodated in the sealed cavity 3. As a material of the second substrate 2, ceramic, glass, silicon, or the like can be utilized.

The electrode 5 is electrically connected to the functional element 4. As a material of the electrode 5, aluminum, an aluminum alloy, or the like can be utilized.

The through electrode 6 is formed in the second substrate 2. Since the metal thin film pad 8 and the metal thin film pad 9 are formed at the corresponding exposed ends of the through electrode 6, an external circuit can be electrically connected to the through electrode 6. Additionally, the functional element 4 can be electrically connected to the through electrode 6. As a material of the through electrode 6, a metal, such as Au, Ag, Ti, or W; an alloy thereof; or a low-resistance poly-silicon can be utilized.

The metal thin film pad 7 electrically connects the electrode 5 and the conductive material 12. The metal thin film pad 7 functions as a pad for improving adhesiveness between the electrode 5 and the metal thin film pad 7, and adhesiveness between the metal thin film pad 7 and the conductive material 12. In addition, the metal thin film pad 7 functions as a barrier layer for preventing metallic materials from diffusing.

Since the metal thin film pad 7 has a plurality of functions, the metal thin film pad 7 can preferably be formed to have a laminated structure.

For a boundary layer (e.g., a first layer) of the metal thin film pad 7 facing the electrode 5, for which enhancement of adhesiveness may be prioritized, a metal, such as Cr or Ti; or an alloy thereof can preferably be utilized. Further, for the barrier layer (e.g., a second layer) of the metal thin film pad 7, for which prevention of diffusion of metallic materials may be prioritized, a metal, such as Pt or Ni; or an alloy thereof can preferably be utilized. Further for a boundary layer (e.g., a third layer) of the metal thin film pad 7, for which enhancement of adhesiveness may be prioritized, a metal, such as Au, Ag, or Cu; or an alloy thereof can preferably be utilized.

The metal thin film pad 8 electrically connects the conductive material 12 and the through electrode 6. Similar to the metal thin film pad 7, the metal thin film pad 8 may function as a pad for enhancing adhesiveness between the conductive material 12 and the metal thin film pad 8, and between the metal thin film pad 8 and the through electrode 6. Additionally, the metal thin film pad 8 may function as a barrier layer for preventing metallic materials from diffusing. Similar to the metal thin film pad 7, the metal thin film pad 8 can preferably be formed to have a laminated structure.

As a material of the metal thin film pad 8, a material that is the same as that of the metal thin film pad 7 can be utilized.

The metal thin film pad 9 may function as a under-barrier metal (UBM) layer for the plating layer 10. By using the UBM layer, an intermetallic compound layer, which is formed on a boundary surface between the plating layer 10 and the through electrode 6, can be prevented from growing, and thereby interface strength can be increased between the plating layer 10 and the metal thin film pad 9, and between the metal thin film pad 9 and the through electrode 6.

As a material of the metal thin film pad 9, a metal, such as Ti, Cr, Ni, or Al, can be utilized.

The plating layer 10 may be required for finally solder mounting the device 100 according to the embodiment onto a printed circuit board. As a material of the plating layer 10, a metal, such as Ni, Au, Ag, or Cu, can be utilized.

In the device 100 according to the embodiment, by using a less expensive and hard material as the joining material 11, and by using a soft and highly conductive material as the conductive material 12, an optimum material may be selected for vacuum sealing the functional element 4, and another optimum material can be selected for electrically connecting the functional element 4 and the package substrate. Additionally, vacuum sealing and electrical connection can be made at the same time, at a wafer level. Accordingly, highly reliable and less expensive joining can be made.

Hereinafter, another example of the device according to the embodiment is explained. FIG. 2 is a cross-sectional view showing an example of a structure of a device 101. There are mainly explained elements of the device 101 which are different from those of the device 100 shown in FIG. 1. The same reference numerals are attached to elements of the device 101 that are the same as those of the device 100.

The structure of FIG. 2 is different from that of FIG. 1 in a point that a material which is utilized as the material of the package substrate (a second substrate 13) is Low Temperature Co-fired Ceramic (LTCC), which is different from usual ceramics, glass, silicon, or the like.

By using the LTCC substrate as the second substrate 13, a shape and a position of an internal wiring 16 can be more freely arranged, and controlling of the shape and the position can be facilitated. Accordingly, when the internal wiring 16 is formed in the package substrate, electrical connection between the metal thin film pad 9 and the conductive material 12 can be ensured, even if the position of the metal thin film pad 9 and the position of the conductive material 12 are freely arranged relative to a case in which the through electrode 6 is formed in the package substrate, as shown in the device 100. By creating a suitable pattern shape of the internal wiring 16, even if the metal thin film pad 9 and the conductive material 12 are not arranged in the same straight line in the vertical direction, the metal thin film pad 9 and the conductive material 12 can be electrically connected.

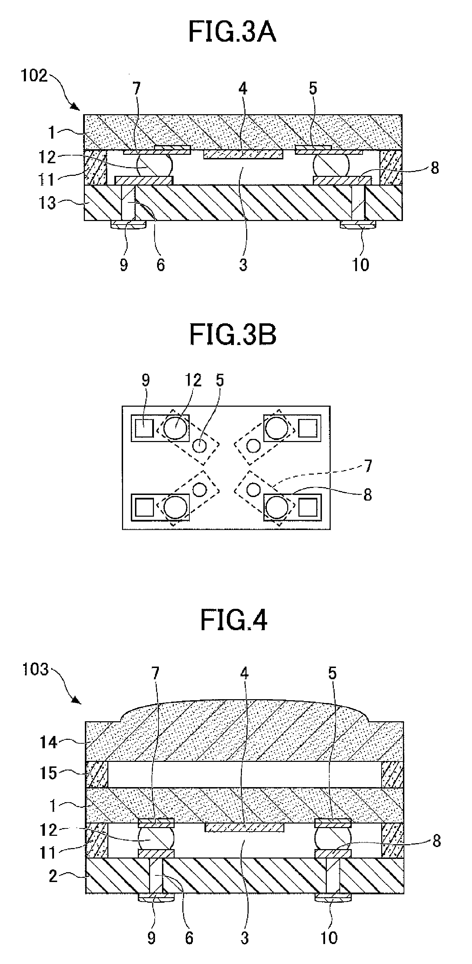

Hereinafter, another example of the device according to the embodiment is explained. FIG. 3A is a cross-sectional view showing an example of a structure of another device 102 according to the embodiment. FIG. 3B is a planar transparent view showing the example of the structure of the device 102 according to the embodiment.

There are mainly explained portions of the device 102, which are different from those of the device 100 shown in FIG. 1. The same reference numerals are attached to elements of the device 102, which are the same as those of the device 100.

In the device 100 shown in FIG. 1, the electrode 5, the metal thin film pad 9, and the conductive material 12 are arranged in the same straight line in the vertical direction. For electrical connection, alignment of these positions may be required. Thus, for designing, there may be a limitation on the layout.

In the device 102 shown in FIG. 3A, the electrode 5, the metal thin film pad 9, and the conductive material 12 are not arranged in the same straight line in the vertical direction. Namely, as shown in FIG. 3B, the position of the electrode 5, the position of the metal thin film pad 9, and the position of the conductive material 12 are shifted relative to each other.

Even in such a case, by the structure of the device 102, the electrode 5, the metal thin film pad 9, and the conductive material 12 can be electrically connected.

For example, by using the metal thin film pad 7, the electrode 5 and the conductive material 12 can be electrically connected. Similarly, for example, by using the metal thin film pad 8, the conductive material 12 and the through electrode 6 can be electrically connected.

Namely, as shown in FIG. 3A, the metal thin film pad 7 and the metal thin film pad 8 are used as internal wirings. The metal thin film pad 7 is formed to be extended, so that the electrode 5 and the conductive material 12 are electrically connected. Similarly, the metal thin film pad 8 is formed to be extended, so that the conductive material 12 and the through electrode 6 are electrically connected. In this manner, by creating suitable pattern shapes of the metal thin film pad 7 and the metal thin film pad 8, even if all the positions of the electrode 5, the metal thin film pad 9, and the conductive material 12 are shifted in the vertical direction, the electrode 5, the metal thin film pad 9, and the conductive material 12 can be electrically connected.

The degree of freedom of designing the layout is high for the device 102 shown in FIG. 3. Since designing can be made while freely arranging the positions of the electrode 5, the metal thin film pad 9, and the conductive material 12, such a layout can be easily implemented.

In the device 102, the through electrode 6 is formed in the package substrate. However, the device 102 may demonstrate the effect which is the same as that of the internal wiring 16 of the LTCC substrate 13 or that of a wafer-level chip size package (wafer-level CSP). Accordingly, the device 102 can be highly integrated and downsized.

Hereinafter, another example of the device according to the embodiment is explained. FIG. 4 is a cross-sectional view showing an example of a structure of a device 103 (a semiconductor device) according to the embodiment. There are mainly explained elements of the device 103 that are different from those of the device 100 shown in FIG. 1. The same reference numerals are attached to elements of the device 102 that are the same as those of the device 100.

FIG. 4 is different from FIG. 1 in a point that a third substrate 14 is formed on the first substrate 1. In the device 103 according to the embodiment, bonding can be made between the first substrate 1 and the second substrate 2 through the joining material 11, and between the first substrate 1 and the third substrate 14 through a joining material 15, simultaneously.

The material of the joining material 15 may be the same as that of the joining material 11.

In the third substrate 14, for example, a lens may be formed. Further, in accordance with expected expansion of the application of the MEMS device from now on, in the third substrate 14, various types of elements may be formed, such as an integrated circuit (IC), a large scale integrated circuit (LSI), an optical communication device, a mobile communication device, or an acceleration sensor for an automobile airbag.

In FIG. 4, the example is shown in which three substrates are laminated and simultaneously bonded. However, the number of the substrate to be laminated is not particularly limited. As shown in the device 103, by adopting a laminated structure in which a plurality of substrates are three dimensionally laminated, and by simultaneously bonding these substrates by using the same joining material, processes for manufacturing the device can be significantly reduced, and downsizing of the device can be expected.

### (Manufacturing method of device)

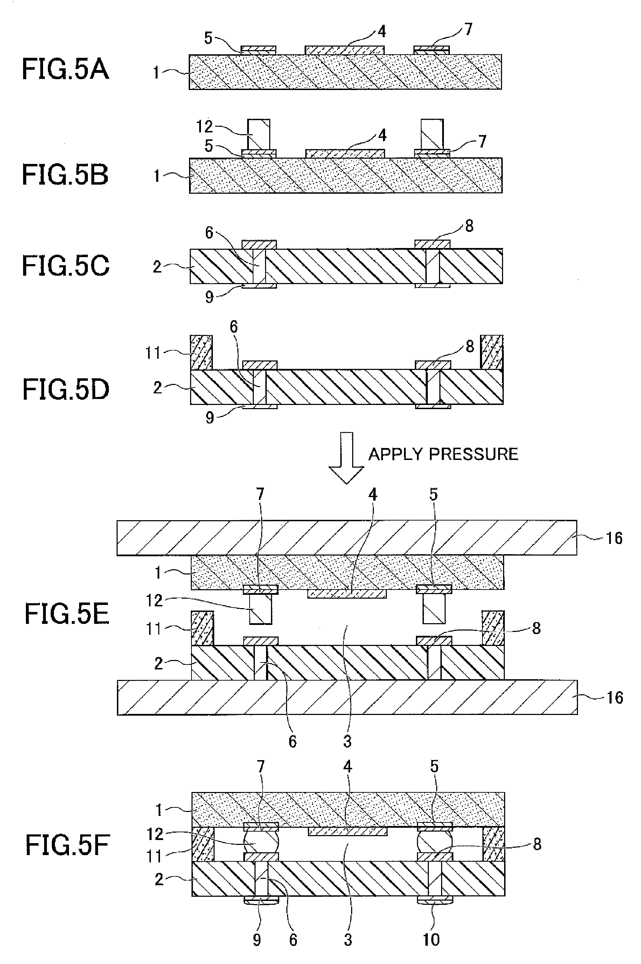

FIGS. 5A- 5F are diagrams showing an example of a method of manufacturing the device 100. Hereinafter, the method of manufacturing the device 100 is explained by referring to FIGS. 5A - 5F.

As shown in FIG. 5A, the functional element 4, such as an IC or a sensor, is formed on the first substrate 1 (e.g., a silicon substrate), similar to a process of manufacturing a generic MEMS.

Subsequently, by the sputtering method or the like, the electrode 5 is formed. The electrode 5 may be formed to have film thickness of approximately from 0.5 µm to 3.0 µm by using aluminum or an alloy of aluminum.

The metal thin film pad 7 is formed on the electrode 5 by the sputtering method or the like. The metal thin film pad 7 may be formed to have a width which is substantially the same as the width of the electrode 5, or formed to have a width which is greater than or equal to the width of the electrode 5. The metal thin film pad 7 may have a three-layer laminated structure. The metal thin film pad 7 may be formed to have film thickness of approximately from 100 nm to 5000 nm.

Specifically, as the first layer, for example, a Ti layer, a Cr layer, or a layer of an alloy thereof may be formed. The first layer may have a function as an adhesive layer. The second layer is formed on the first layer. As the second layer, for example, a Ni layer, a Pt layer, or a layer of an alloy thereof may be formed. The second layer may have a function as a barrier layer for preventing metallic materials from dispersing. The third layer is formed on the second layer. As the third layer, for example, an Au layer, an Ag layer, a Cu layer, or a layer of an alloy thereof may be formed. The third layer may have a function as an alloy layer for alloying an upper layer (which is the conductive material 12).

In the embodiment, the example is explained in which the metal thin film pad 7 may have the three-layer laminated structure. However, the structure of the metal thin film pad 7 is not limited to this structure. The metal thin film pad 7 may have a laminated structure other than the three-layer laminated structure.

Next, as shown in FIG. 5B, the conductive material 12 is formed on the metal thin film pad 7.

The conductive material 12 is formed so as to electrically connect the electrode 5 to the through electrode 6 during bonding in the next process. The electrode 12 may be formed by patterning, such as screen printing, by using a noble metal, such as Au or Ag, or a paste material of an alloy thereof and a solder material, etc. Film thickness of the conductive material 12 depends on spacing of the cavity 3, namely, the distance between the first substrate 1 and the second substrate 2. The conductive material 12 may be formed to have the film thickness of approximately from 10 µm to 50 µm.

The conductive material 12 may be formed of a relatively soft and highly conductive material (e.g., a paste material). Further, the conductive material 12 can preferably be formed of a baked material, whose melting temperature is lower than 400 °C - 450 °C.

Subsequent to forming the conductive material 12, in order to remove an unnecessary solvent, the conductive material 12 (the past material) is prebaked. The temperature of prebaking can preferably be a temperature which is suitable for removing gas and moisture within the paste material. By removing the unnecessary solvent and removing the unnecessary gas and moisture by prebaking, more reliable bonding can be made during a joining process explained later. Further, the temperature of prebaking can preferably be a temperature which is lower than joining temperature of the joining process of explained later. Accordingly, the temperature of prebaking can preferably be approximately from 200 °C to 400 °C.

Next, as shown in FIG. 5C, the through electrode 6 is formed in the second substrate 2 (e.g., a glass substrate). The metal thin film pad 8 is formed at one exposed end of the through electrode 6. Similarly, the metal thin film pad 9 is formed at the other exposed end of the through electrode 6.

The metal thin film pad 8 may be formed of a material which is the same as that of the metal thin film pad 7. For example, the metal thin film pad 8 may be formed to have the three-layer laminated structure (e.g., a Ti layer, a Cr layer, or a layer of an alloy thereof / a Ni layer, a Pt layer, or a layer of an alloy thereof / an Au layer, an Ag layer, a Cu layer, or a layer of an alloy thereof). The metal thin film pad 8 may be formed to have film thickness of approximately from 100 nm to 5000 nm.

The metal thin film pad 9 may be formed by using, for example, Ti, Cr, Ni, Pt, Au, Ag, Cu or Al. The metal thin pad 9 may be formed to have film thickness of approximately from 100 nm to 10 µm.

Subsequently, as shown in FIG. 5D, the joining material 11 is formed on the second substrate 2. The joining material 11 is formed so as to bond the first substrate 1 and the second substrate 2 in the joining process explained later.

The joining material 11 may be formed by patterning with a method, such as screen printing, by using a glass frit material or a polymer resin. Since the film thickness of the joining material 11 may determine the spacing of the cavity 3, the joining material 11 may be formed to have the film thickness of approximately from 10 µm to 50 µm. In order to make height of the joining material 11 uniform, a glass bead material may be added to the glass frit material, for example.

The joining material 11 can preferably be formed of a relatively hard and less expensive material.

In order to prevent an adverse effect on the functional element which may be caused by high temperature, the joining material 11 can preferably be formed of a baked material, whose melting temperature is lower than 400 °C - 450 °C. Specifically, the glass frit material can preferably be utilized.

Since the melting temperature of the joining material 11 and the melting temperature of the conductive material 12 are substantially the same, bonding of the first substrate 1 and the second substrate 2 for vacuum sealing, and electrical connection between the first substrate 1 and the second substrate 2 can be made simultaneously.

After pattern-forming the joining material 11, the joining material 11 is prebaked so as to remove an unnecessary solvent. The temperature of prebaking can preferably be approximately from 200 °C to 400 °C.

Next, as shown in FIG. 5E, the device substrate (which is produced in FIG. 5B) and the package substrate (which is produced in FIG. 5D) are joined.

By using a joining machine, the first substrate 1 and the second substrate 2 are pressed, and the first substrate 1 and the second substrate 2 are heated. The heating temperature during joining can preferably be approximately from 350°C to 450°C. Namely, the heating temperature can preferably be temperature at which the functional element 4 is not adversely affected, and at which the joining material 11 (e.g., the glass frit material) and the conductive material 12 (e.g., an Ag paste material) can be baked and cured.

In the joining machine 16, the degree of vacuum inside the cavity 3 is adjusted. As described above, the unnecessary solvent, gas, and moisture are removed from the joining material 11 and from the conductive material 12 by prebaking. Prebaking is an important process for making high precision vacuum sealing. By such prebaking and vacuum drawing by the joining machine during bonding, the unnecessary gas and air can almost completely be removed from the cavity 3. By adjusting the degree of vacuum inside the cavity 3 by the joining machine 16 in such a condition, high precision bonding can be made.

As shown in FIG. 5F, after bonding, the conductive material 12 is squashed by heating and pressing by the joining machine 16, and the conductive material 12 and the metal thin film pads 7 and 8 are electrically connected by diffusion joining between the conductive material 12 and the metal thin film pads 7 and 8.

Since the joining material 11 is harder than the conductive material 12, as shown in FIG. 5, it is almost unlikely that, after bonding, the joining material 11 will be deformed by heating and pressing by the joining machine 16. Namely, by the film thickness of the joining material 11, the predetermined spacing is reserved between the first substrate 1 and the second substrate 2, thereby forming the cavity 3. Accordingly, the functional element 4 can be vacuum-sealed inside the cavity 3, without separately providing a space in the package substrate.

According to the above-described joining process, the first substrate 1 and the second substrate 2 can be flat plates. Thus, a redundant process, such as a process of forming a separate space for accommodating the functional element, can be omitted.

Finally, the plating layer 10 is formed to contact the metal thin film pad 9. The plating layer may be formed to have film thickness of approximately from 100 nm to 100 µm by using Ni, Au, Ag, or Cu, for example.

With the manufacturing method according to the embodiment, the predetermined spacing can be stably reserved between the first substrate 1 and the second substrate 2, and the functional element 4 can be vacuum-sealed with high precision, by bonding the first substrate 1 and the second substrate 2 by using the joining material 11, which is harder and less conductive than the conductive material 12. At the same time, by using the soft conductive material 12, whose conductivity is high, and by making diffusion joining, electrical connection between the electrode 5 (which is formed on the first substrate 1) and the through electrode 6 (which is formed in the second substrate 2) can be ensured.

Further, by forming the joining material 11 with a less expensive material, bonding can be made with low cost.

Namely, according to the above-described device and method of manufacturing the device, by selecting an optimum material for electrical connection and an optimum material for vacuum sealing, and by making bonding and electrical connection at the same time at the wafer-level, less expensive and highly reliable bonding can be made.

Hereinafter, another example of the device according to the embodiment is explained.

### (Structure of device)

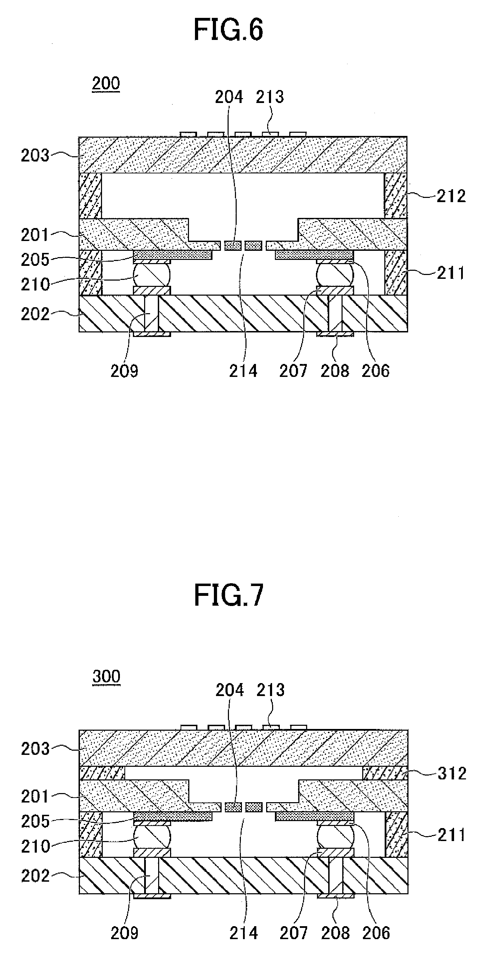

FIG. 6 is a cross-sectional view showing an example of a device 200 according to the embodiment.

The device 200 includes a first substrate 201; a second substrate 202; a third substrate 203; a functional element 204; a drive control circuit 205 (including an electrode); a metal thin film pad 206; a metal thin film pad 207; a metal thin film pad 208; a through electrode 209; a conductive material 210; a first joining material 211; a second joining material 212; an optical element 213; and a cavity (space) 214.

The first substrate 201 includes the functional element 204; and the drive control circuit 205 for driving the functional element 204. The functional element 204 (e.g., an optical sensor, a pressure sensor, an infrared sensor, and/or an acceleration sensor) can be formed by using a known micro-fabrication technique and/or a known thin film forming technique. In addition to various types of sensors, the functional element 204 may include an actuator, such as an oscillator. The conductive material 210 is disposed between the electrode of the drive control circuit 205 and the through electrode 209.

As an example of a material of the first substrate 201, Si, or silicon on insulator (SOI) may be considered.

The through electrode 209 is formed in the second substrate 202. The metal thin film pad 207 is formed at an end of the through electrode 209, and the metal thin film pad 208 is formed at the other end of the through electrode 209. The functional element 204 can be electrically connected to an external circuit through the through electrode 209.

A material of the second substrate 202 is not particularly limited, provided that the material is an insulator. For example, glass or a ceramic material may be considered as a material of the second substrate 202.

The optical element 213 is formed on the third substrate 203. The optical element 213 may be formed by using a known thin film forming technique. The optical element 213 may be a diffraction grating, a lens, or a filter, for example.

As an example of a material of the third substrate 203, Si may be considered.

The conductive material 210 is disposed between the drive control circuit 205 and the through electrode 209. An electric current may flow between the drive control circuit 205 and the through electrode 209 through the conductive material 210, the metal thin film pad 206, and the metal thin film pad 207. The metal thin film pad 206 is formed at an end of the conductive material 210, and the metal thin film pad 207 is formed at the other end of the conductive material 210.

As a material of the conductive material 210, a soft material having high electric conductivity may preferably be utilized such that the material can easily be squashed by pressure and heat during bonding. Additionally, the material of the conductive material 210 may preferably have endurance against temperature during solder reflow, such as solder joining. For example, as a material of the conductive material 210, a metal, such as Au, Ag, or Al; a paste material or a solder material of an allow thereof; or porous Au may be used.

The metal thin film pad 206 may have a layered structure formed of three layers. For example, the metal thin film pad 206 may have a laminated structure formed of a Cr layer, a Pt layer, and an Au layer. In such a case, in order to enhance conductivity, the Au layer may be formed on the surface that contacts the conductive material 210, and the Cr layer may be formed on the other surface that contacts the drive circuit 25.

Similarly, the metal thin film pad 207 may have a layered structure formed of three layers. For example, the metal thin film pad 207 may have a laminated structure formed of a Cr layer, a Pt layer, and an Au layer. In such a case, the Au layer may be formed on the surface that contacts the conductive material 210 so as to enhance conductivity. The Cr layer may be formed on the surface that contacts the second substrate 202 so as to enhance adhesiveness. The Pt layer may be formed between the Au layer and the Cr layer, so that Pt layer may be prevented from diffusing. Instead of the Cr layer, a Ti layer may be used. Additionally, instead of the Pt layer, a Ni layer may be used.

Similarly, the metal thin film pad 208 may have a layered structure formed of three layers. In such a case, the Au layer may be formed on the surface contacting the outside. The Cr layer may be formed on the surface that contacts the second substrate 202 so as to enhance adhesiveness. The Pt layer may be formed between the Au layer and the Cr layer, so that Pt layer may be prevented from diffusing.

The first joining material 211 is formed between the first substrate 201 and the second substrate 202. The first joining material 211 joins the first substrate 201 and the second substrate 202. The first substrate 201 and the second substrate 202 are joined through the first joining material 211, while the first substrate 201 and the second substrate 202 are separated by a predetermined distance. In this manner, the functional element 204 can be vacuum sealed. The cavity 214 is provided between the first substrate 201 and the second substrate 202. The cavity 214 may be used to package the functional element 204.

As a material of the first joining material, a glass frit material, or a polymer resin may preferably be utilized.

The thickness of the first joining material 211 may preferably be approximately 20 µm. By setting the thickness of the first joining material 211 to be greater than the thickness of the functional element 204 (e.g., approximately 10 µm), the functional element 204 may be prevented from interfering with the second substrate 202, after joining the first substrate 201 and the second substrate 202.

The width of the first joining material 211 may preferably be approximately 150 µm. Here, the width of the first joining material 211 may suitably be adjusted, so that a distance between the functional element 204 and the joining material 211 may be greater than or equal to 50 µm.

The second joining material 212 is formed between the first substrate 201 and the third substrate 203. The second joining material 212 joins the first substrate 201 and the third substrate 203. The first substrate 201 and the third substrate 203 are joined through the second joining material 212, while the first substrate 201 and the third substrate 203 are separated by a predetermined distance. Here, the distance between the first substrate 201 and the third substrate 203 may suitably be adjusted by changing the thickness of the second joining material 212.

The thickness of the second joining material 212 may be adjusted to be the same as that of the first joining material 211. The width of the second joining material 212 may be adjusted to be the same as that of the first joining material 211. The material of the second joining material 212 may be selected to be the same as that of the first joining material 211.

By setting the thickness, the width, and the material of the second joining material 212 to be the same as those of the first joining material 211, the device 200 may be produced by a simple process, and cost for producing the device 200 may be reduced. The optical element 212 is formed on the third substrate 203. The functional element 204 is formed in the first substrate 201. Thus, by laminating the third substrate 203 on the first substrate 201, the device 200 having a multi-substrate structure can be obtained. The device 200 may be compact, but the device 200 may have an advanced feature. Additionally, the device 200 can be produced by the less expensive process.

Hereinafter, another example of the device according to the embodiment is explained. FIG. 7 is a cross-sectional view of an example of a structure of a device 300. Some elements of the device 300 may be the same as corresponding elements of the device 200 shown in FIG. 6. Accordingly, elements of the device 300 that are different from corresponding elements of the device 200 are mainly explained. The elements of the device 300 that are the same as those of the device 200 are denoted by the corresponding same reference numerals.

The device 300 may include a second joining material 312 that is different from the second joining material 212 of the device 200. The thickness and the width of the second joining material 312 are different from those of the first joining material 211. The material of the second joining material 312 is the same as the material of the first joining material 211.

As shown in FIG. 7, the thickness of the second joining material 312 may be adjusted to be less than the thickness of the first joining material 211. For example, the thickness of the second joining material 312 may be adjusted to be approximately 10 µm. The width of the second joining material 312 may be adjusted to be greater than the width of the first joining material 211. For example, the width of the second joining material 312 may be adjusted to be approximately 200 µm.

In this manner, by setting the thickness of the second joining material 312 to be less than the thickness of the joining material 211, the distance between the optical element 213 and the functional element 204 can be decreased. Accordingly, positioning accuracy of the optical element 213 relative to the functional element 204 can be enhanced, and optical characteristics of the functional element 204 can be enhanced.

When individual devices are to be formed by dividing an wafer in which the plurality of the devices are formed, dividing positions may easily be adjusted by setting the width of the second joining material 312 to be greater than the width of the first joining material 211. Accordingly, high precision dicing can be performed, and downsizing of the device 300 may be achieved relatively easily.

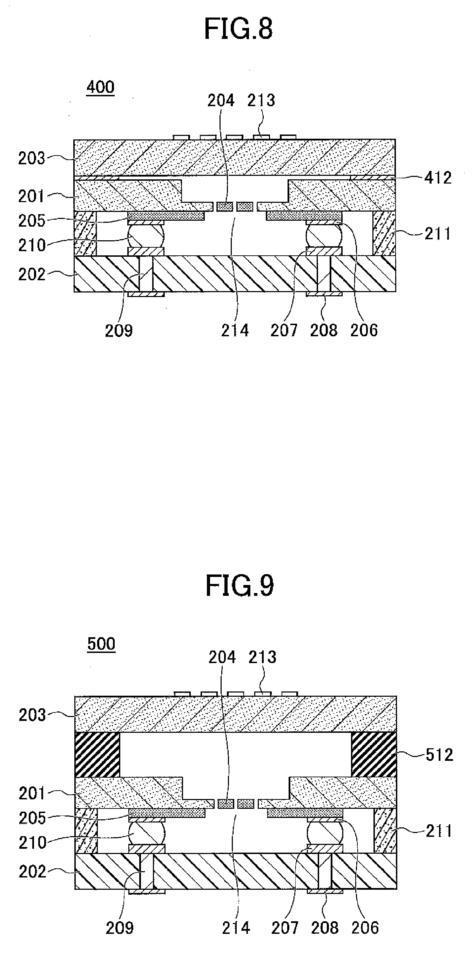

Hereinafter, another example of the device according to the embodiment is explained. FIG. 8 is a cross-sectional view of an example of a structure of a device 400. Some elements of the device 400 may be the same as corresponding elements of the device 200 shown in FIG. 6. Accordingly, elements of the device 400 that are different from corresponding elements of the device 200 are mainly explained. The elements of the device 400 that are the same as those of the device 200 are denoted by the corresponding same reference numerals.

The device 400 may include a second joining material 412 that is different from the second joining material 212 of the device 200. The thickness, the width, and the material of the second joining material 412 are different from those of the first joining material 211.

As shown in FIG. 8, the thickness of the second joining material 412 may be adjusted to be less than the thickness of the first joining material 211. For example, the thickness of the second joining material 412 may be adjusted to be approximately 1 µm. The width of the second joining material 412 may be adjusted to be greater than the width of the first joining material 211. For example, the thickness of the second joining material 412 may be adjusted to be approximately 200 µm. a metal may be selected as a material of the second joining material 412. For example, an alloy of Au and Sn may be selected as the material of the second joining material 412.

In this manner, by selecting a metal as the material of the second joining material 412, gas generation can be suppressed. Consequently, during joining, joining temperature of the second joining material 412 may be set to be lower than joining temperature of the first joining material 211. The device 400 can be hermetically sealed with a high degree of vacuum at relatively low temperature. Accordingly, even if the manufacturing process is simplified, the performance of the device 400 can be maintained.

Hereinafter, another example of the device according to the embodiment is explained. FIG. 9 is a cross-sectional view of an example of a structure of a device 500. Some elements of the device 500 may be the same as corresponding elements of the device 200 shown in FIG. 6. Accordingly, elements of the device 500 that are different from corresponding elements of the device 200 are mainly explained. The elements of the device 500 that are the same as those of the device 200 are denoted by the corresponding same reference numerals.

The device 500 may include a second joining material 512 that is different from the second joining material 212 of the device 200. The width and the material of the second joining material 512 are different from those of the first joining material 211. The thickness of the second joining material 512 is the same as the material of the first joining material 211.

As shown in FIG. 9, the width of the second joining material 512 may be adjusted to be greater than the width of the first joining material 211. For example, the width of the second joining material 512 may be adjusted to be approximately 200 µm. A polymer resin may be selected as the material of the second joining material 512. For example, a polyimide resin may be selected as the material of the second joining material 512.

By selecting a polyimide resin as the material of the second joining material 512, joining temperature of the second joining material 512 may be set to be less than or equal to 300 °C. In other words, joining can be made at low temperature. Accordingly, the material of the third substrate 203 and the material of the functional element 204 can be selected from a broader range of materials. For example, as the material of the third substrate 203 and the functional element 204, organic materials may be selected. Consequently, material cost of the device 500 may be reduced.

As explained, for each the devices 200, 300, 400, and 500, the thickness, the width, and the material of the second joining material (212, 312, 412, or 512) may be changed relative to the thickness, the width, and the material of the first joining material 212, depending on various conditions. Accordingly, each substrate may be joined by using a corresponding optimized joining material. Thus, less expensive and highly reliable joining can be made. Additionally, the first joining material and the second joining material join the substrates, and at the same time, the first joining material and the second joining material package the functional element 204. Accordingly, a manufacturing process can be simplified, and at the same time a compact device having an advanced feature can be produced.

### (Manufacturing method of device)

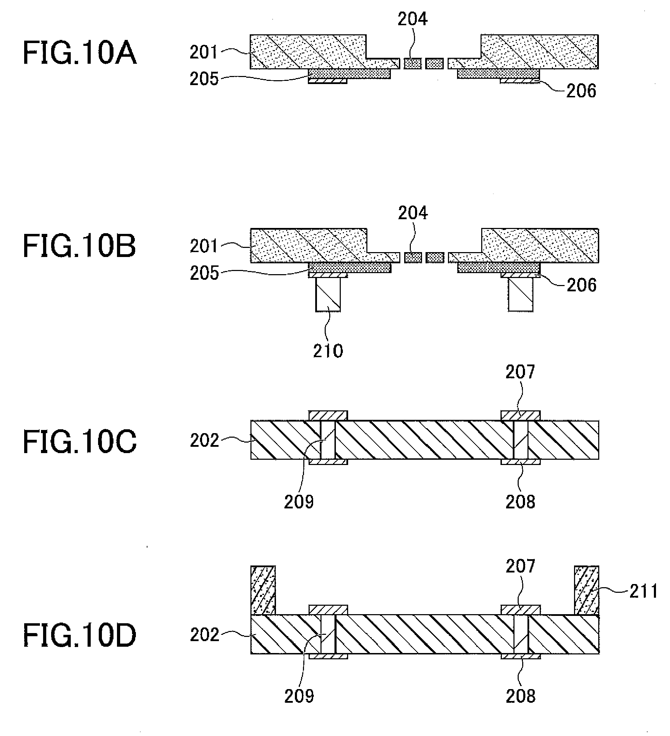

FIGS. 10A - 10D are diagrams illustrating an example of a method of manufacturing the device 200. Hereinafter, the example of the method manufacturing the device 200 is explained by referring to FIGS 10A - 10D.

First, as shown in FIG. 10A, the functional element 204 and the drive control circuit 205 are formed in the first substrate (e.g., a silicon substrate) 201 by a known micro-fabrication technique and/or a known thin film forming technique.

Then, the metal thin film pad 206 is formed, for example, by the sputtering method, so that the metal thin film pad 206 contacts the drive control circuit 205. An electrode (which is formed of Al, for example) is formed in the drive control circuit 205. The metal thin film pad 206 is formed so as to electrically connect the electrode and the conductive material 210. Here, the conductive material 210 is to be formed later. The metal thin film pad 206 may have a layered structure that is formed of three layers (e.g., a Cr layer, a Pt layer, and a Au layer). The thickness of the metal thin film pad 206 may be approximately from 100 nm to 5000 nm.

Next, as shown in FIG. 10B, the conductive material 210 (e.g., Ag paste) having a dot-like shape is formed, for example, by screen printing, so that the conductive material 210 contacts the metal thin film pad 206. When the Ag paste is utilized as a material of the conductive material 210, sufficient heating and baking at approximately 200 °C may preferably be performed for the conductive material 210, so that a solvent and binder can be removed.

The diameter of the dot-like shape of the conductive material 210 may preferably be approximately 150 µm. The diameter of the dot-like shape of the conductive material 210 may preferably be less than the size of the metal thin film pad 206 and the size of the metal thin film pad 207.

The conductive material 210 may preferably be formed, so that, after heating and baking, the film thickness of the conductive material 210 may be approximately 20 µm. The film thickness of the conductive material 210 may be adjusted, so that the film thickness of the conductive material 210 may be greater than the film thickness of the metal thin film pad 206 and the film thickness of the metal thin film pad 207.

Next, as shown in FIG. 10C, the through electrode 209 is formed in the second substrate (e.g., a glass substrate) 202. At an exposed end of through electrode 209, the metal thin film pad 207 is formed by the sputtering method, for example. At the other exposed end of the through electrode 209, the metal thin film pad 208 is formed by the sputtering method, for example. Each of the metal thin film pad 207 and the metal thin film pad 208 may have a layered structure that is formed of, for example, three layers (e.g., a Cr layer, a Pt layer, and a Au layer). The film thickness of each of the metal thin film pad 207 and the metal thin film pad 208 may be approximately 100 nm to 5000 nm.

Next, as shown in FIG. 10D, the first joining material 211 (e.g., a glass frit material) is formed on the second substrate 202, for example, by screen printing, so that the first joining material 211 surrounds the functional element 204 and the through electrode 209. The first joining material 211 may be formed, so that the film thickness of the first joining material 211 may be approximately from 10 µm to 50 µm.

By drying and baking the first joining material 211, a solvent and binder are removed. Additionally, by applying a heating process at a temperature that may be greater than or equal to 400 °C, the first joining material 211 can be vitrified. In this manner, while the first substrate 201 and the second substrate 202 are joined, the functional element 204 can be vacuum sealed.

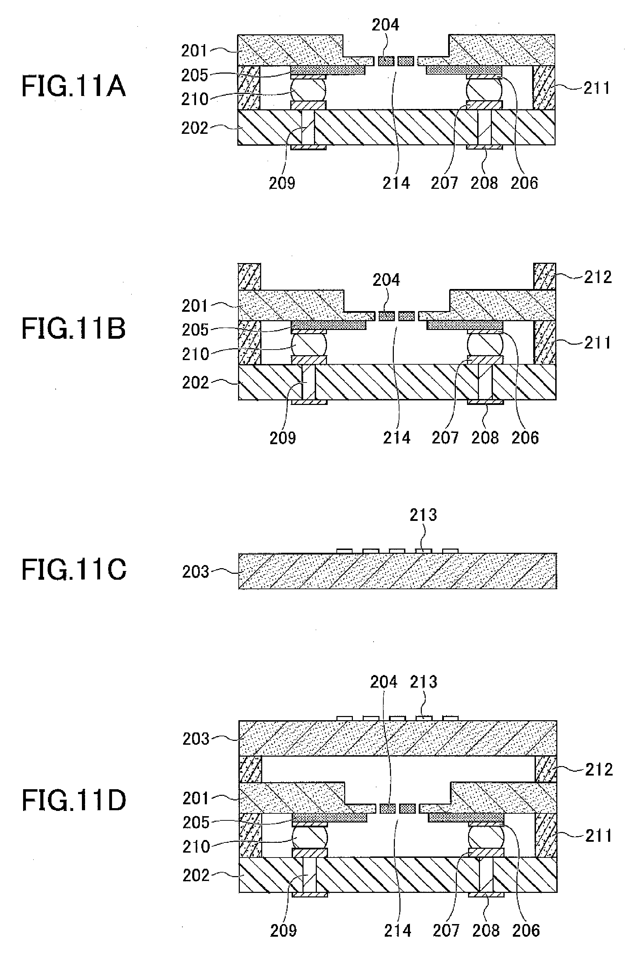

Next, as shown in FIG. 11A, a position of the device substrate (the first substrate 201) produced by the process of FIG. 10B is aligned with a position of the package substrate (the second substrate 202) produced by the process of FIG. 10D, and subsequently the first substrate 201 and the second substrate 202 are joined.

Then, the first substrate 201 and the second substrate 202 are pressed by a joining machine, and the first substrate 201 and the second substrate 202 are heated (i.e., thermocompression bonded). The heating temperature during joining may preferably be approximately from 350 °C to 450 °C. In other words, the heating temperature during joining may preferably be a temperature at which the first joining material 211 (e.g., a glass frit material) and the conductive material 210 (e.g., Ag paste) can be baked and hardened without adversely affecting the functional element 204.

After joining the first substrate 201 and the second substrate 202, the conductive material 210 is squashed by heating and pressing by the joining machine, and the conductive material 210 are joined to the metal thin film pads 206 and 207 by diffusion joining. In this manner, the conductive material 210 and the metal thin film pads 206 and 207 can be electrically connected.

The first joining material 211 is formed of a material that is harder than that of the conductive material 210. Accordingly, after joining the first substrate 201 and the second substrate 202, the first joining material 211 may not be deformed by heating and pressing by the joining machine. Namely, a predetermined space corresponding to the film thickness of the first joining material 211 can be reserved between the first substrate 201 and the second substrate 202, and thereby the cavity 214 is formed. The functional element 204 can be vacuum sealed in the cavity 214, without separately forming a space in the package substrate. According to the above-described joining process, each of the first substrate 201 and the second substrate 202 can be a flat substrate. Thus, a redundant process, such as forming a space for accommodating the functional element 204, may be omitted.

Next, as shown in FIG. 11B, the second joining material 212 (e.g., a glass frit material) is formed on the second substrate 202 by screen printing, for example. By drying and baking the second joining material 212, a solvent and binder are removed. Subsequently, by applying a heating process at a temperature of greater than or equal to 400 °C, the second joining material 212 can be vitrified. In this manner, during joining the first substrate 201 and the third substrate 203, the functional element 204 can be vacuum sealed from a reverse direction.

Next, as shown in FIG. 11C, the optical element 212 (e.g., an optical filter) is formed by a known micro-fabrication technique and/or a known thin film forming technique.

Next, as shown in FIG. 11D, a position of the device substrate (the first substrate 201) formed by the process of FIG. 11B is aligned with a position of the substrate (the third substrate 203) formed by the process of FIG. 11C, and the first substrate 201 and the third substrate 203 are joined.

Then, the first substrate 201 and the third substrate 203 are pressed by a joining machine, and the first substrate 201 and the third substrate 203 are heated (i.e., thermocompression bonded). During joining the first substrate 201 and the third substrate 203, the heating temperature may preferably be greater than the heating temperature for joining the first substrate 201 and the second substrate 202.

As described above, the first substrate 201 and the second substrate 202 are joined by using the first joining material 211. The material of the first joining material 211 can be optimized for certain conditions. Separately from joining the first substrate 201 and the second substrate 202, the first substrate 201 and the third substrate 203 are joined by using the second joining material 212. The material of the second joining material 212 can be optimized for some conditions. Accordingly, high precision joining can be made. Even if various components are formed in substrates and a plurality of the substrates are laminated, joining strength and joining reliability can still be enhanced. Consequently, a device having an advanced feature can be produced.

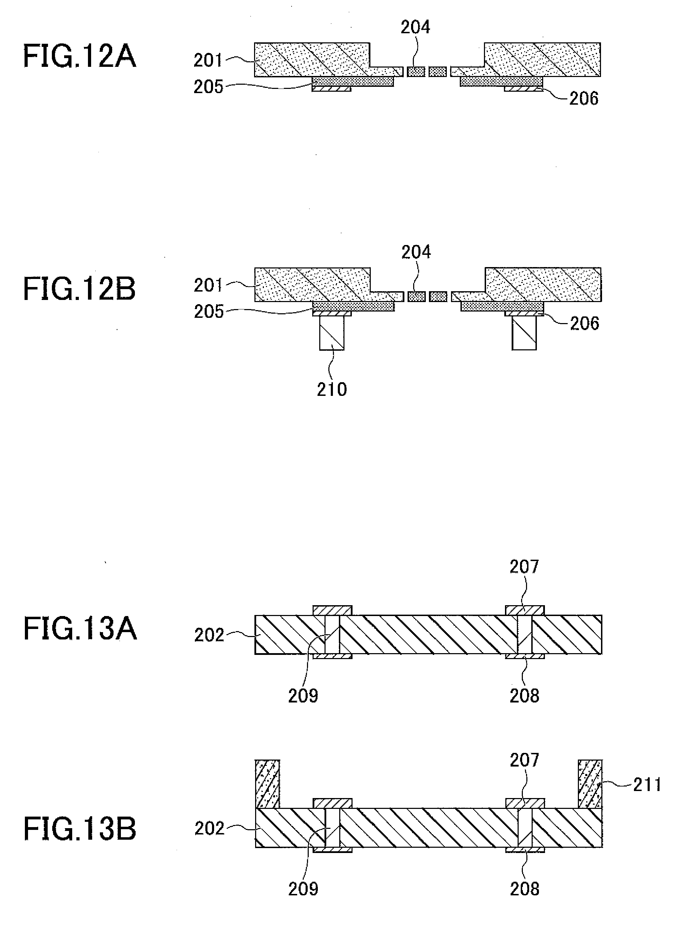

Alternatively, as shown in FIGS. 12 - 15, the device 200 may be produced by simultaneously joining all the substrates.

In this case, as shown in FIG. 12A, the functional element 204 and the drive control circuit 205 are formed in the first substrate 201. Then, as shown in FIG. 12B, the conductive material 210 is formed.

Next, as shown in FIG. 13A, the through electrode 209 is formed in the second substrate 202. As shown in FIG. 13B, the first joining material 211 is formed on the second substrate 202.

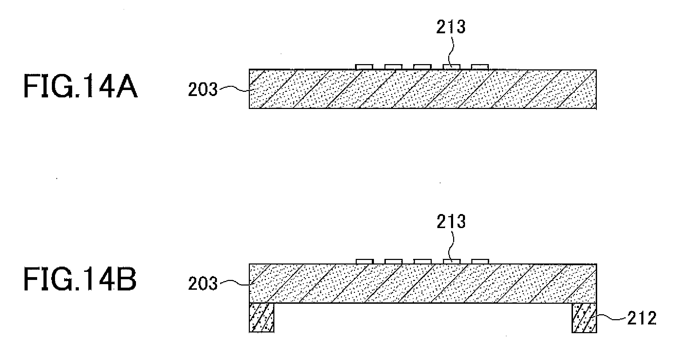

Next, as shown in FIG. 14A, the optical element 213 is formed on the third substrate 203. As shown in FIG. 14B, the second joining material 212 is formed on the other surface of the third substrate 203.

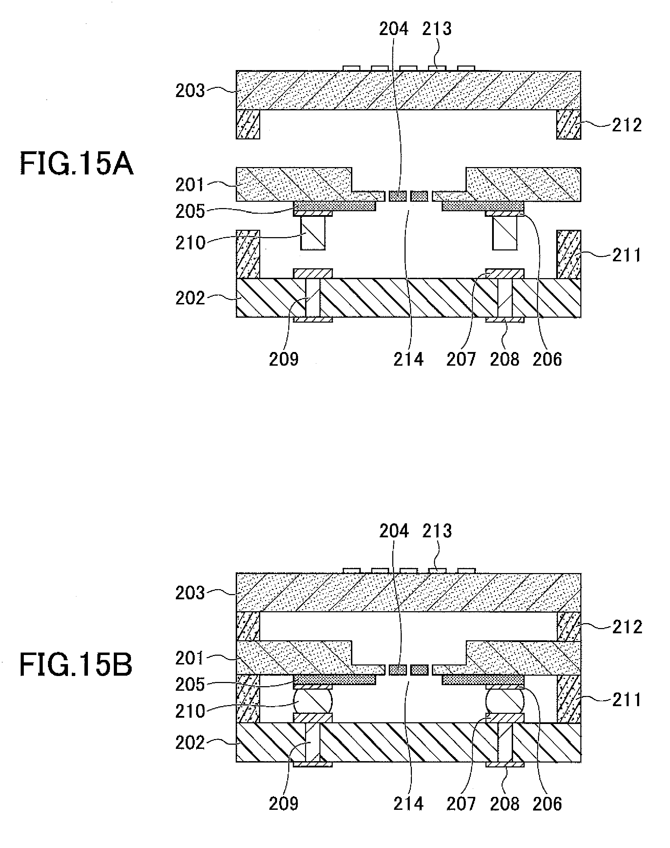

After that, as shown in FIG. 15A, positions of the substrates formed by the processes of FIGS, 12B, 13B, and 14B, respectively, are aligned with each other. Then, as shown in FIG. 15B, the first substrate 201, the second substrate 202, and the third substrate 203 are simultaneously joined.

The first substrate 201, the second substrate 202, and the third substrate 203 are pressed by a joining machine, and the first substrate 201, the second substrate 202, and the third substrate 203 are heated (i.e., thermocompression bonded). The heating temperature for joining may preferably be approximately from 350 °C to 450 °C.

As described above, by simultaneously joining all the substrates, the manufacturing process can be simplified. Accordingly, cost for producing the device 200 can be reduced.

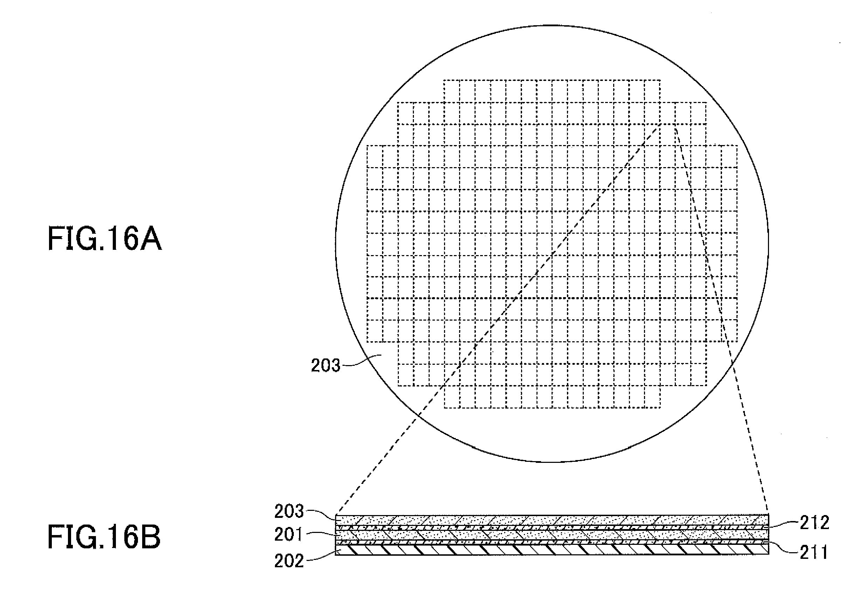

Additionally, as shown in FIG. 16A, the first joining material 211, the second joining material 212, and a plurality of functional elements 204 may be formed in the corresponding substrates at a wafer-level. After that, the substrates may be joined. Then, as shown in FIG. 16B, the wafer may be divided so as to form the individual devices 200.

In this case, a plurality of the devices 200 can be formed by an integrated process. Accordingly, cost for producing the device 200 may be reduced.

Hereinabove, the device, the semiconductor device, and the method of manufacturing the device are explained by the embodiment. However, the present invention is not limited to the specifically disclosed embodiment, and variations and modifications may be made without departing from the scope of the present invention.

The present application is based on and claims the benefit of priority of Japanese Priority Application No. 2013-032383 filed on February 21, 2013, and Japanese Priority Application No. 2014-004274 filed on January 14, 2014, the entire contents of which are hereby incorporated herein by reference.

## Claims

1. A semiconductor device comprising:
a first substrate in which a functional element and an electrode are formed;
a second substrate in which a through electrode is formed;
a joining material that joins the first substrate and the second substrate, while reserving a predetermined space between the functional element and the second substrate; and
a conductive material that electrically connects the electrode to the through electrode,
wherein the joining material is harder than the conductive material, and the joining material is electrically less conductive than the conductive material.

2. The semiconductor device according to claim 1,
wherein the joining material and the conductive material are formed of corresponding baked materials having the same melting temperature.

3. The semiconductor device according to claim 1 or claim 2,
wherein the joining material is a glass frit material or a polymer resin.

4. The semiconductor device according to any one of claims 1 to 3,
wherein the conductive material is Au, Ag, a paste material including Au and Ag, or a solder material including Au and Ag.

5. The semiconductor device according to any one of claims 1 to 4,
wherein the functional element is vacuum sealed by the joining material.

6. The semiconductor device according to any one of claims 1 to 5,
wherein each of the first substrate and the second substrate is a flat substrate.

7. The semiconductor device according to claim 1, further comprising:
a third substrate,
a third substrate,
wherein an optical element is formed on the third substrate.

8. The semiconductor device according to claim 7,
wherein the joining material that joins the first substrate and the second substrate is a first joining material, and a joining material that joins the first substrate and the third substrate is a second joining material, and
wherein a thickness and a width of the second joining material are different from those of the first joining material.

9. The semiconductor device according to claim 8,
wherein the first joining material and the second joining material are formed of an identical material.

10. The semiconductor device according to claim 8,
wherein the first joining material is a glass frit material, and the second joining material is a metal.

11. The semiconductor device according to claim 8,
wherein the second joining material is a polymer resin.

12. A method of manufacturing a device, the method comprising:
a step of forming a functional element and an electrode on a first substrate;
a step of forming a conductive material on the electrode;
a step of forming a through electrode in a second substrate;
a step of forming a joining material on the second substrate, wherein the joining material is harder than the conductive material, and the joining material is electrically less conductive than the conductive material;
a step of joining the first substrate and the second substrate through the joining material, while reserving a predetermined space between the functional element and the second substrate; and
a step of electrically connecting the electrode to the through electrode through the conductive material.

13. A method of manufacturing a device, the method comprising:
a step of forming a functional element and an electrode on a first substrate;
a step of forming a conductive material on the electrode;
a step of forming a through electrode in a second substrate;
a step of forming a joining material on the second substrate, wherein the joining material is harder than the conductive material, and the joining material is electrically less conductive than the conductive material,
a step of baking the conductive material and the joining material, while reserving a predetermined space between the functional element and the second substrate;
a step of joining the first substrate and the second substrate through the joining material; and
a step of electrically connecting the electrode and the through electrode through the conductive material.

14. The method according to claim 12,
wherein the joining material that joins the first substrate and the second substrate is a first joining material, and a joining material that joins the first substrate and a third substrate including an optical element is a second joining material, and
wherein the method further includes a step of forming the second joining material, so that a thickness and a width of the second joining material are different from those of the first joining material.
